# EUROPEAN PATENT SPECIFICATION

(11) **EP 2 885 822 B1**
(45) Date of publication and mention of the grant of the patent: **21.09.2016**
(21) Application number: 13777113.5
(22) Date of filing: 19.08.2013
(51) Int. Cl.: F24J 2/46, F28F 3/12, F28F 9/02, H02S 20/00, H02S 30/10, H02S 40/34, H02S 40/44, F24J 2/52, H01L 31/052

(54) **HYBRID SOLAR MODULE FOR THE SIMULTANEOUS PRODUCTION OF ELECTRIC AND THERMIC ENERGY**
HYBRID-SOLARMODUL ZUR GLEICHZEITIGEN ERZEUGUNG VON ELEKTRISCHER UND THERMISCHER ENERGIE
MODULE SOLAIRE HYBRIDE POUR LA PRODUCTION SIMULTANÉE D'ÉNERGIE ÉLECTRIQUE ET THERMIQUE

(30) Priority: 20.08.2012 IT TV20120165; 18.12.2012 IT TV20120238
(43) Date of publication of application: 24.06.2015
(73) Proprietor: Indea S.r.l., 38068 Rovereto (IT)
(72) Inventor: CORVAGLIA, Roberto, I-30022 Ceggia (IT)
(74) Representative: Piovesana, Paolo
(86) International application number: PCT/IB2013/001788
(87) International publication number: WO 2014/030045

(56) References cited:
- WO-A2-2010/128462
- WO-A2-2011/014120
- DE-A1- 10 233 973
- DE-U1-202006 008 614

## Description

The present invention relates to a hybrid solar module for the simultaneous production of electric and thermic energy.

Photovoltaic solar modules are known, i.e. devices able to transform solar radiation into electrical energy, as are thermal solar modules, i.e. devices able to transform solar radiation into thermal energy. Both these modules consist generally of panels to be exposed to solar radiation, this latter striking a capturing surface able to implement the required energy transformation.

Hybrid solar modules are also known, able to convert solar radiation both into electrical energy by utilizing the photovoltaic effect, and into thermal energy by using a thermovector fluid circulating through tubes provided in the surface opposite that proposed for the photovoltaic conversion.

In all these known modules, the system for their fixing to a support structure, generally provided on the roof of a building, uses aluminium profiles which perform the support function for the application of brackets by means of screws and/or bolts.

DE 20 2006 008614U describes a hybrid solar module for producing electrical and thermal energy. It comprises a photovoltaic laminate, an extruded profile which replaces the traditional perimetral structure of a photovoltaic laminate and includes conduits for heat exchange between the thermovector fluid and the photovoltaic laminate, and mounting elements formed in the extruded profile to fix the hybrid module onto a support structure.

An object of the invention is to provide a hybrid solar module which, compared with traditional solutions, presents a low production cost together with considerable ease of installation and high energy efficiency.

This and other objects which will be apparent from the ensuing description are attained according to the invention by a hybrid solar module as described in claim 1.

Preferred embodiments of the invention are further clarified hereinafter with reference to the accompanying drawings, in which:

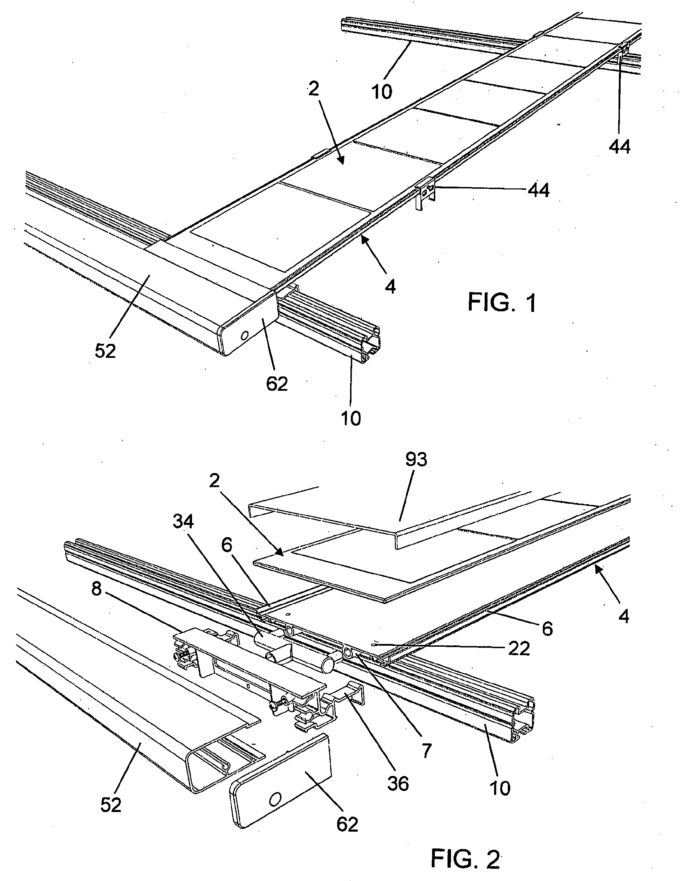

- Figure 1: is a perspective view from above showing a first embodiment of a hybrid solar module according to the invention, fixed to two profiles,
- Figure 2: is a partial exploded perspective view thereof,
- Figure 3: is a perspective detailed view from above showing how a connection terminal is fixed to the tubular conduits of the thermovector fluid circulation circuit,
- Figure 4: is a perspective view from below showing the profile with the electrical connection box highlighted,
- Figure 5: is a perspective view from below showing an end of the hybrid solar module provided with a headpiece,
- Figure 6: is a perspective view from above, seen from the outside, showing a headpiece of the hybrid solar module,
- Figure 7: is a perspective view thereof from above, seen from the inside,

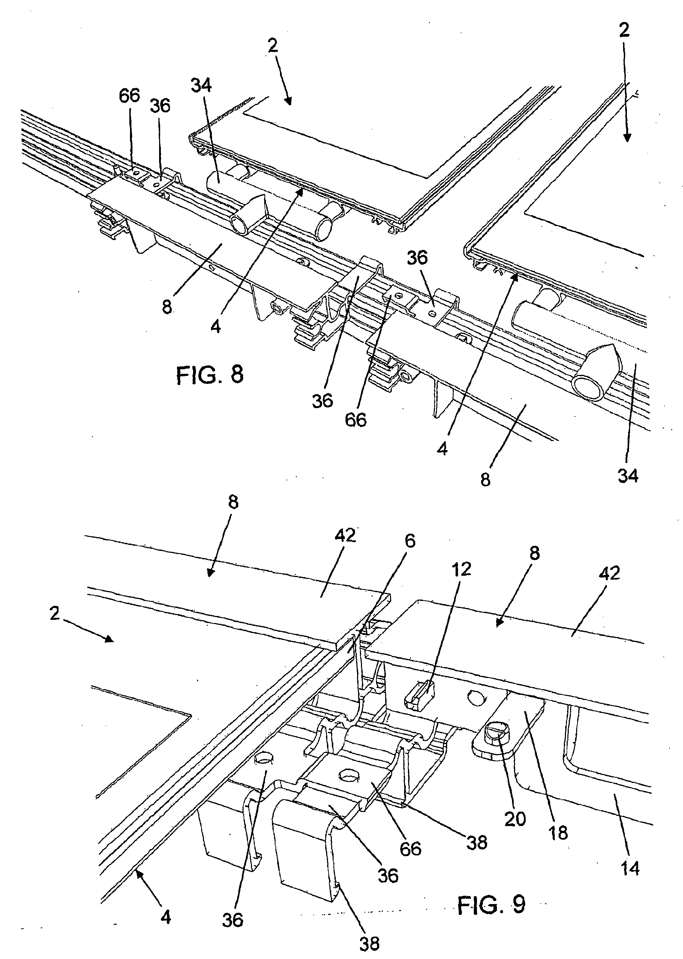

- Figure 8: is an exploded perspective detailed view showing the connection between two adjacent hybrid solar modules,
- Figure 9: is a perspective detailed view showing the connection between two headpieces of two adjacent hybrid solar modules,
- Figure 10: is a perspective view showing a U-bracket for connecting a support profile of a hybrid solar module to a profile of the fixing structure,
- Figure 11: is a perspective detailed view showing the connection between a support profile of a hybrid solar module to a profile of the fixing structure, using the U-bracket of Figure 10.
- Figure 12: is an exploded perspective view thereof,
- Figure 13: is a perspective detailed view showing the connection between a headpiece and a fixing profile for the hybrid solar module,
- Figure 14: is an exploded perspective detailed view showing the connection between a cover profile with plug and a headpiece of the hybrid solar module,
- Figure 15: is a perspective view from above, showing a hybrid solar module according to the invention fixed by a bracket of different shape to the intermediate profiles of the fixing structure,
- Figure 16: is a perspective view thereof from below,
- Figure 17: is an exploded partial perspective view thereof from below,
- Figure 18: is a perspective view of this different bracket from below,
- Figure 19: is a perspective view thereof from above,
- Figure 20: shows a detail of Figure 15,
- Figure 21: is a partial perspective detailed view from above showing the connection between two adjacent U-brackets lowerly connected to the same profile of the fixing structure,
- Figure 22: is an exploded perspective view thereof,
- Figure 23: is a perspective view from above showing a hybrid solar module according to the invention fixed by a U-bracket to a profile of the fixed structure disposed longitudinally to the module,
- Figure 24: is a perspective view thereof from below,
- Figure 25: is a perspective view corresponding to Figure 20 but without the hybrid solar module,
- Figure 26: is a perspective detailed view showing the connection between a hybrid solar module and a different embodiment of a profile of the fixing structure,
- Figure 27: is a partial perspective view from below showing a different embodiment of the extruded support profile for the hybrid solar module according to the invention,
- Figure 28: shows a cross-section therethrough,
- Figure 29: is a plan view thereof from below,
- Figure 30: is a partially interrupted perspective view showing the extension of the conduit for the thermovector fluid, and
- Figure 31: shows in the same view as Figure 15 the extruded support profile with the conduit for the thermovector fluid applied.

As can be seen from the figures, the hybrid solar module according to the invention comprises a photovoltaic laminate 2 (photovoltaic module) applied to an extruded profile 4, preferably made of aluminium, having a length substantially equal to that of the photovoltaic module 2 and of slightly lesser width so that it can be contained between two longitudinal projections 6 provided in both edges of the extruded profile 4. A gasket or other protection element can also be applied to the longitudinal edges of the photovoltaic module 2, likewise contained, together with the module, between the two longitudinal projections 6 of the extruded profile.

The extruded profile 4 presents on its upper side, i.e. on that side facing the photovoltaic module 2, a substantially flat large surface intended for the application of the photovoltaic module, and presents on its opposite side a pair of longitudinal tubular conduits 7, formed in one piece with the profile 4.

The connection between the photovoltaic module 2 and the extruded profile 4 can be made with a butyl adhesive, with a biadhesive tape, or with another material having both adhesive and thermoconductive characteristics.

The assembly formed by the photovoltaic module 2 and the underlying extruded profile 4 forms a unit having optimal mechanical characteristics and considerable and uniform mechanical strength.

The hybrid solar module according to the invention also comprises a pair of headpieces 8, preferably formed by injection-moulding a polymer material, possibly filled with glass fibre.

Each headpiece 8 is snap-fitted to the corresponding end of the extruded profile 4 and performs the double function of fixing element between the photovoltaic module 2 and the extruded profile 4 and of fixing element for the combination formed by the two fixing profiles 10, themselves connected to an underlying fixed structure, for example the structure of a building roof.

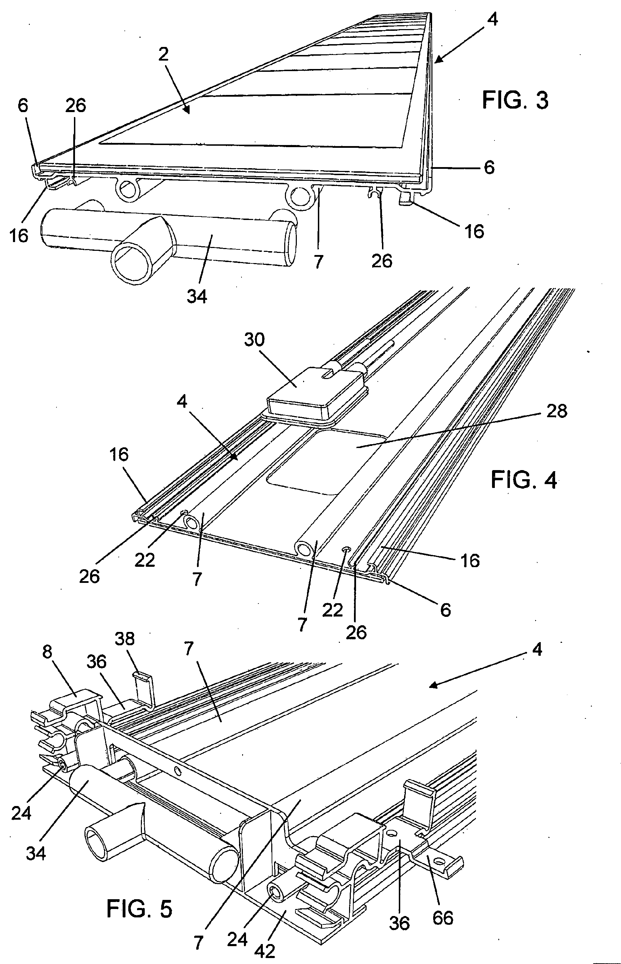

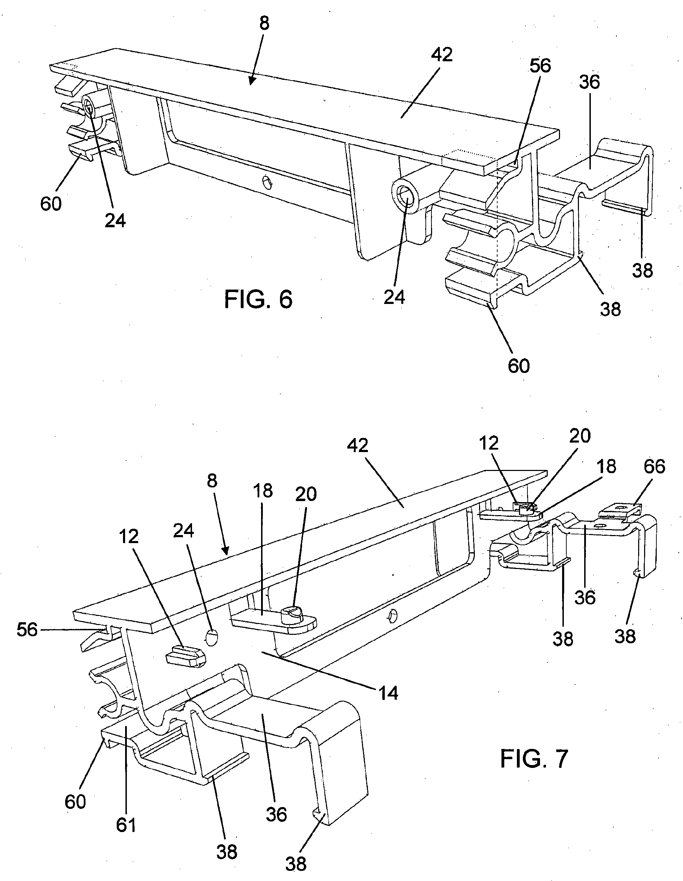

Correct provisional positioning of each headpiece 8 on the extruded profile 4 is ensured by the engagement of a pair of centring appendices 12 (Figure 7), projecting inwards from a vertical wall 14 of the headpiece 8, in corresponding L-shaped ribs 16 (Figure 3), projecting from the lower surface of the profile 4, i.e. from that surface opposite the surface to which the photovoltaic module 2 is applied.

This correct provisional positioning or pre-mounting of each headpiece 8 is then followed by its stable fixing achieved both by mutually cooperating snap elements and by screw fixing means.

The snap fixing elements can consist of flexible clips 18 projecting inwards perpendicularly from the wall 14 of the headpiece 8 and provided at their end with a cylindrical peg 20 which lowerly engages a corresponding hole 22 provided in the flat portion of the profile 4.

Screw fixing means can consist of screws passing through corresponding holes 24 provided in the vertical wall 14 of the headpiece and engaging in open longitudinal grooves 26, provided in the lower surface of the extruded profile 4.

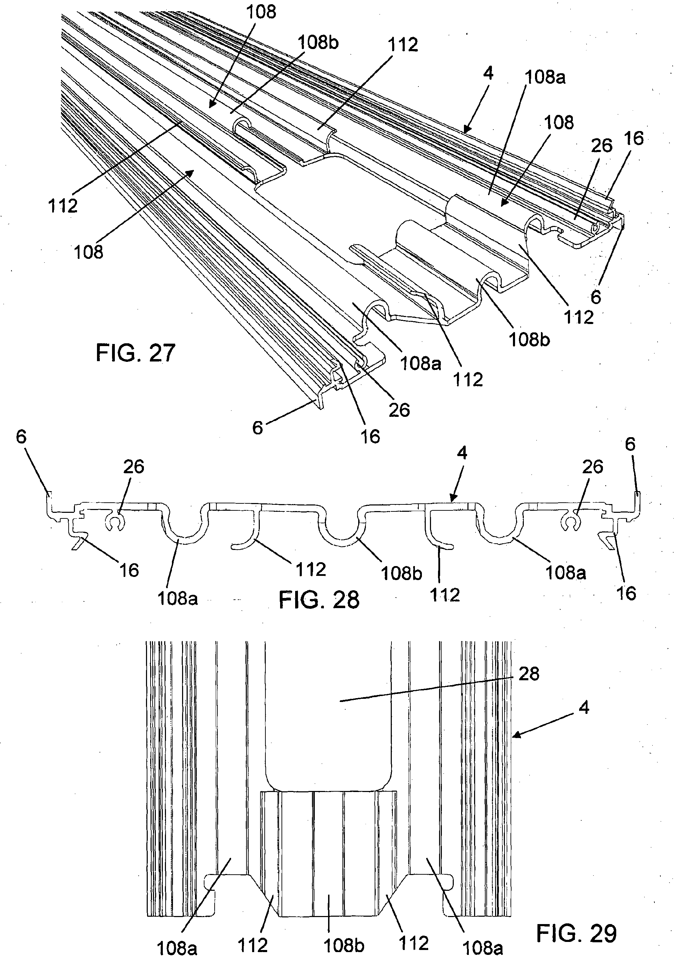

The extruded profile 4 also comprises an aperture 28 (Figures 4 and 29) intended to house a traditional junction box 30 applied to the lower surface of the photovoltaic module 2. This aperture can be formed by milling or by laser cutting or any other method and involves a flat portion of the profile 4.

Watertight connection terminals 34 can be applied to the ends of the conduits 7 for connection to the external hydraulic circuit, or metal or plastic tube portions fixed by welding or adhesive.

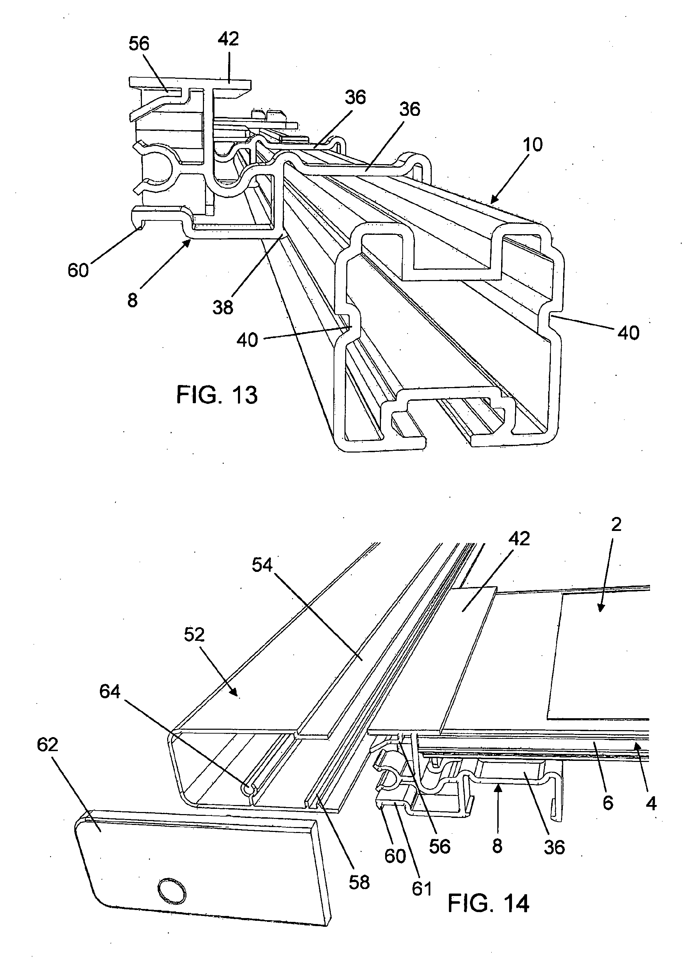

Each headpiece 8 is also provided with a pair of fork elements 36, with two elastic prongs provided at their lower end with a rib 38, for snap engagement in two longitudinal grooves 40 (Figure 13) provided on the two opposing vertical sides of the fixing profile 10, to ensure that the headpiece 8, and hence the entire hybrid solar module, is locked to it.

In addition to the vertical wall 14, each headpiece 8 also presents a horizontal wall 42, the function of which is to retain the photovoltaic module 2 fixed to the extruded profile 4, as an alternative to or in addition to adhesives.

The fixing profiles 10 can be provided only at the ends of the hybrid solar module, i.e. at the two headpieces 8 thereof, or can also be provided in intermediate positions, in which case they require specific elements for fixing the hybrid solar module thereto.

These fixing elements can consist of particular U-brackets or clips 44, which comprise an inverted U-shaped lower portion having two prongs provided at their lower end with two ribs snap-engaging in the longitudinal grooves 40 of the profile 10. Each clip also comprises a C-shaped upper portion, with the lower web also forming the central web of the underlying inverted U portion, and with the upper web intended to overlie the corresponding upper edge portion of the photovoltaic module 2 to maintain it adhering to the underlying profile 4 even in the absence of adhesives and to fix both to the intermediate fixing profile 10.

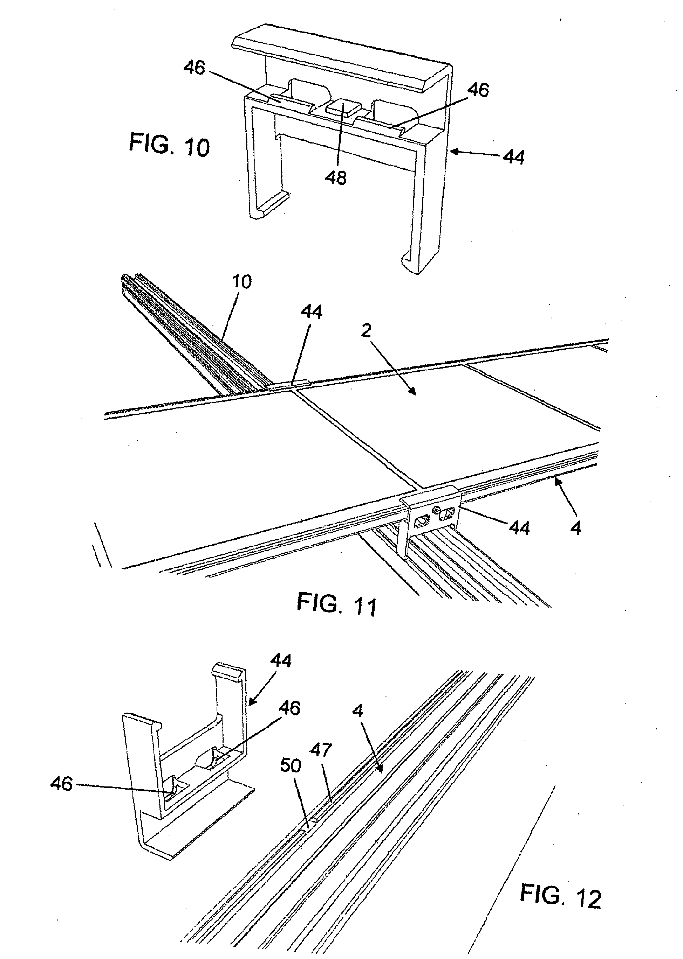

The stability of the connection of each clip 44 to the profile 4 is ensured, with regard to movements perpendicular to the edge thereof, by the snap-engagement of projections 46 provided in the clip 44, in a corresponding longitudinal projection 47 present in the lower edge of the profile and, with regard to movements parallel to the edge thereof, by the engagement of an appendix 48, provided inside the C-shaped portion of the clip 44, in a corresponding interruption 50 of the projection 47 (Figure 12).

To each headpiece 8 an essentially C-shaped cover profile 52 can be fitted, with the outer edge 54 of its upper horizontal web engaging by insertion in a corresponding groove 56 provided in the horizontal wall 42 of the headpiece 8, and with a groove 58, provided in the lower web and snap-engagable by an appendix 60, provided on a flexible strip 61, with which each headpiece 8 is provided.

The function of this cover profile 52, which is advantageously applicable to several adjacent hybrid solar modules, is to protect and hide from view the hydraulic and electrical connections therebetween, and can be closed at one or both ends by a plug 62. This can be fixed to the cover profile 52 by a screw, which passes through the plug and engages in a tubular groove 64 provided in the cover profile.

In practical use several hybrid solar modules are mounted mutually adjacent on a single support structure, i.e. on a single pair of fixing profiles 10, hence according to the invention the headpieces 8 of each module are provided with means for securely connecting adjacent modules together.

More particularly, the two fork elements 36, which fix each headpiece 8 to the fixing profile 10, are positioned at the ends of the headpiece, one of these having its central portion which joins the two prongs together being provided with a lateral appendix 66, intended for its fixing by traditional means (self-tapping screws, bolt and nut, etc...) to the central portion of the fork element 36 of the adjacent hybrid solar module.

Advantageously, the upper surface of the horizontal wall 42 of the headpiece 8 is shaped to enable self-locking engagement of the lower base of another headpiece which is stacked on the first during transport or assembly. More particularly, the upper surface of the horizontal wall 42 can present apertures 67 (represented by dashed lines in Figure 6) to be engaged by corresponding appendices 60 of the flexible strip 61 of the headpiece 8 of the overlying module (in this case these appendices 60 must evidently be higher than that shown in Figure 6).

From the aforegoing it is apparent that the hybrid solar module of the invention is particularly advantageous compared with traditional hybrid solar modules and in particular:
- it has considerable structural rigidity, particularly appreciated during both installation and use,
- it effectively uses the radiant element, which dissipates the heat of the photovoltaic module and increases its efficiency, including for hot water production,
- it can be constructed with dimensions which make it easy to handle (typically 200 x 20 cm) and facilitate its installation,
- it is easy to assemble from its components and is hence of very simple construction,
- it can be installed quickly, effectively and securely on the fixing structure
- it enables several hybrid solar modules to be superposed while preventing slippage during handling and transport by virtue of the self-locking connection between the headpieces.

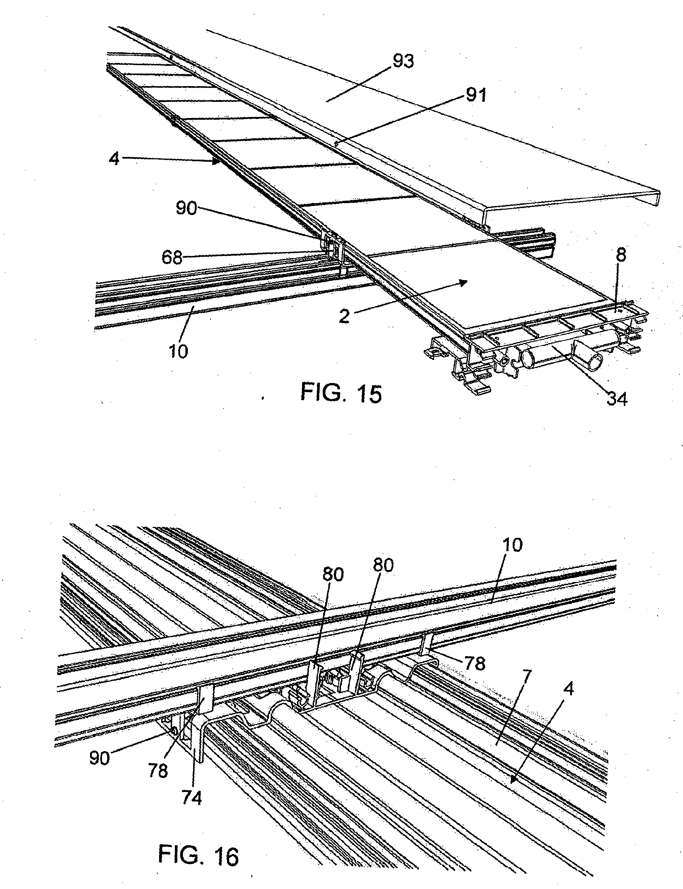

The invention also makes it possible to fix the hybrid solar module to the intermediate profiles of the fixing structure 10 by U-brackets 68 shown in Figures 15 to 26. These U-brackets 68 are preferably formed by injection-moulding plastic material, for example glass fibre-reinforced polyamide. In particular, by virtue of the construction material of the U-brackets 68 and their configuration, they present considerable elasticity which enables them to be quickly mounted on the extruded profile 4. Alternatively, the U-bracket 68 can be constructed of sheet metal by blanking/bending and progressive stamping.

The U-bracket 68 extends longitudinally with a contour which substantially reproduces the lower transverse contour of the extruded profile 4 which supports the photovoltaic module 2, i.e. it upperly presents a central flat portion 70, to the sides of which two substantially semi-cylindrical seats 72 are provided to embrace the conduits 7 of the extruded profile 4. In addition, the ends of the body of the U-bracket 68 are bent at 90° upwards to form two vertical walls 74, provided at their top with hook projections 76. The vertical walls 74 are intended to laterally embrace the combined extruded profile 4 and photovoltaic module 2, while the hook projections 76 are intended to lock the extruded profile 4 to the photovoltaic module 2.

A pair of first elongated hooks 78 is provided on the lower side of the U-bracket 68 in proximity to each of the walls 74, extending from the opposite side to the walls 74 and facing each other at a distance apart substantially equal to the width of the fixing profile 10. Consequently, the two pairs of first hooks 78 are able to lock a fixing profile 10 disposed transversely to the extruded profile 4, which is associated upperly with the U-bracket 68 (see Figures 15-17).

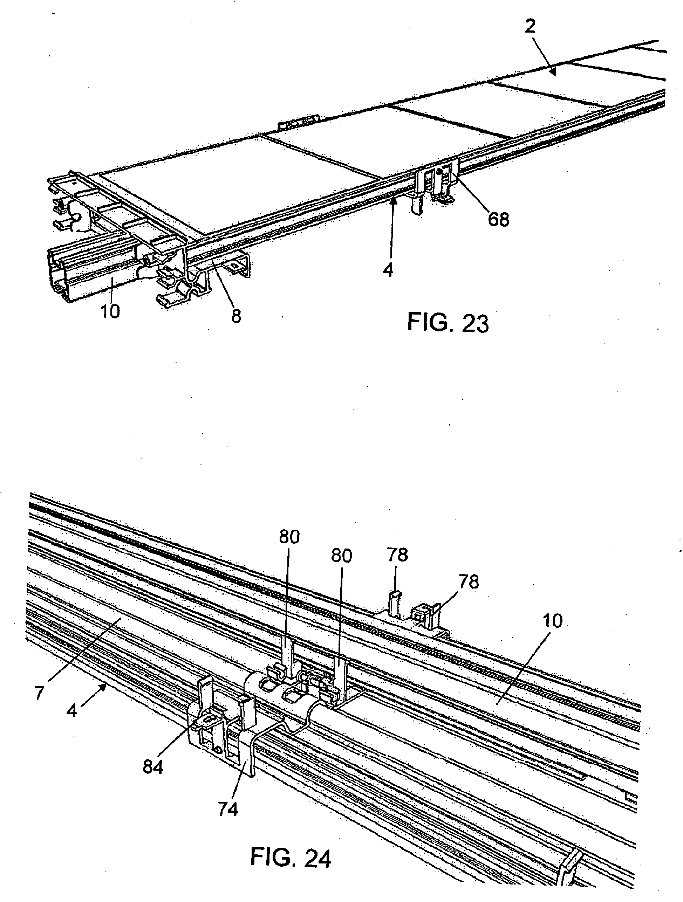

In addition, the U-bracket 68 is provided centrally on its lower face with two pairs of second elongated hooks 80, these being rotated through 90° with respect to the hooks 78. They are intended to engage a fixing profile 10 disposed parallel to the hybrid solar module, i.e. longitudinally to the extruded profile 4 (see Figures 23 and 24). This fixing method is particularly advantageous in that it avoids problems deriving from aluminium expansion.

The U-bracket 68 is also provided with projecting appendices 82, 84 provided at different heights on each of the opposing short sides of the U-bracket and provided respectively with an aperture 86 and a hooking tooth 88, which form the elements by which two U-brackets of two adjacent modules can be connected together.

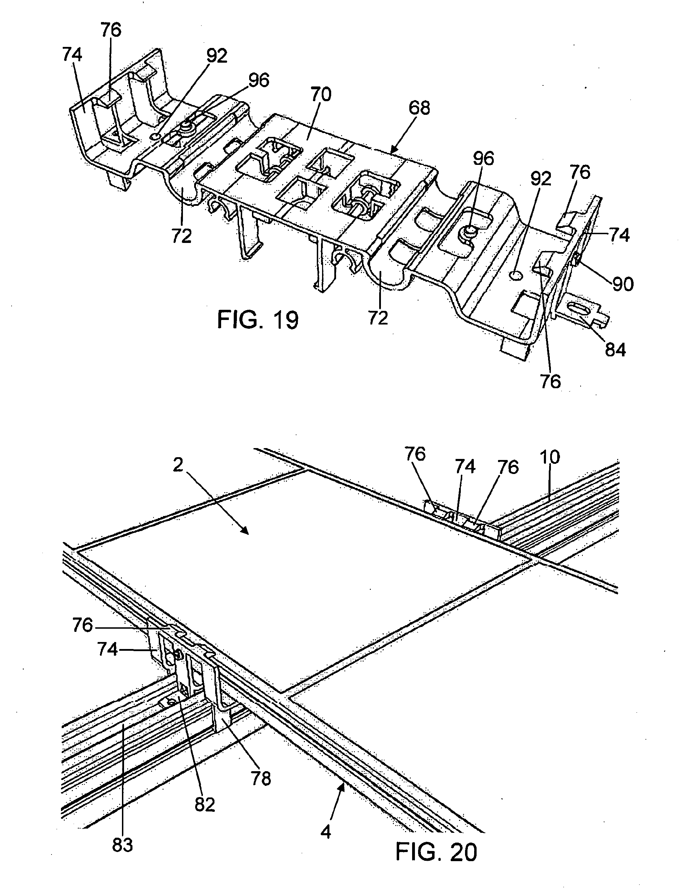

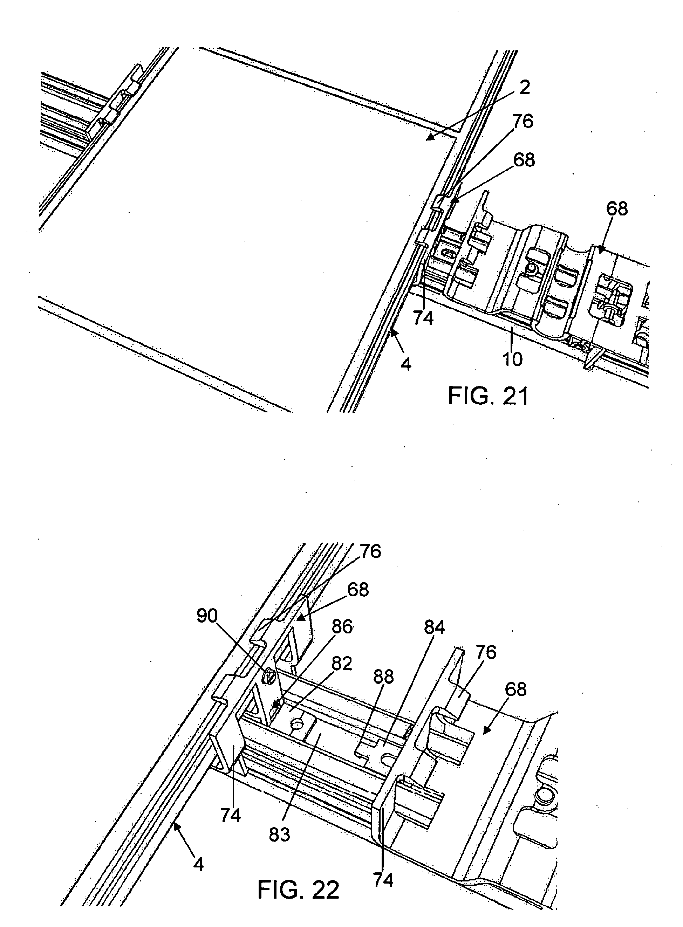

More particularly, as shown in Figures 21, 22, the appendices 82, 84 can slide along a longitudinal groove 83 provided in the upper horizontal side of the fixing profiles 10 (see Figure 20), then after the first solar module has been finally fixed to the fixing profile 10, another module can be connected to the first quickly and securely by simply bringing together the U-brackets 68 to which the nodules are locked, and causing the appendices 82, 84 thereof to snap-engage, by causing a hooking tooth 68 of the projecting appendix 84 of one U-bracket 68 to pass through the aperture 86 of the projecting appendix 82 of the adjacent U-bracket.

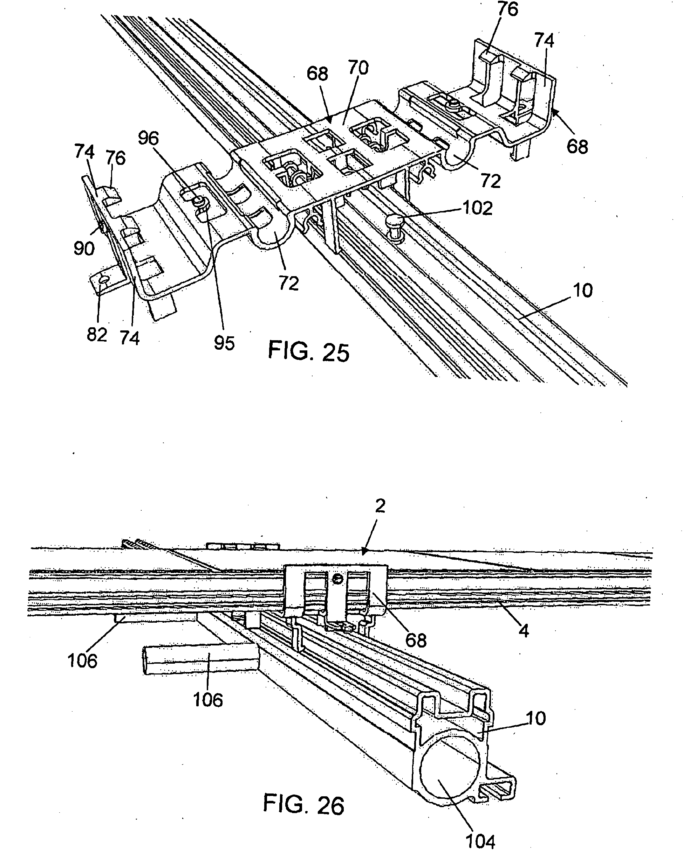

The vertical walls 74 of the U-bracket 68 are also provided externally with projecting pegs 90 intended to engage in holes 91 of an extruded cover 93 (see Figure 15), which can be transparent or semi-transparent and partly coloured: the upper face of the U-bracket 68 also presents, on elastic strips 95 (see Figure 25) for contacting the extruded profile 4, further projecting pegs 96 for secure engagement in corresponding holes, not shown, provided in the lower side of the profile.

In addition, the U-bracket 68 presents, on flat zones intended to come into contact with the fixing profiles 10, hollow cylindrical appendices 92 (see Figure 19) housing magnets to interact, during preassembly, with other magnets or with magnetic or metallic bands, possibly housed in the longitudinal groove 83 of the fixing profile 10.

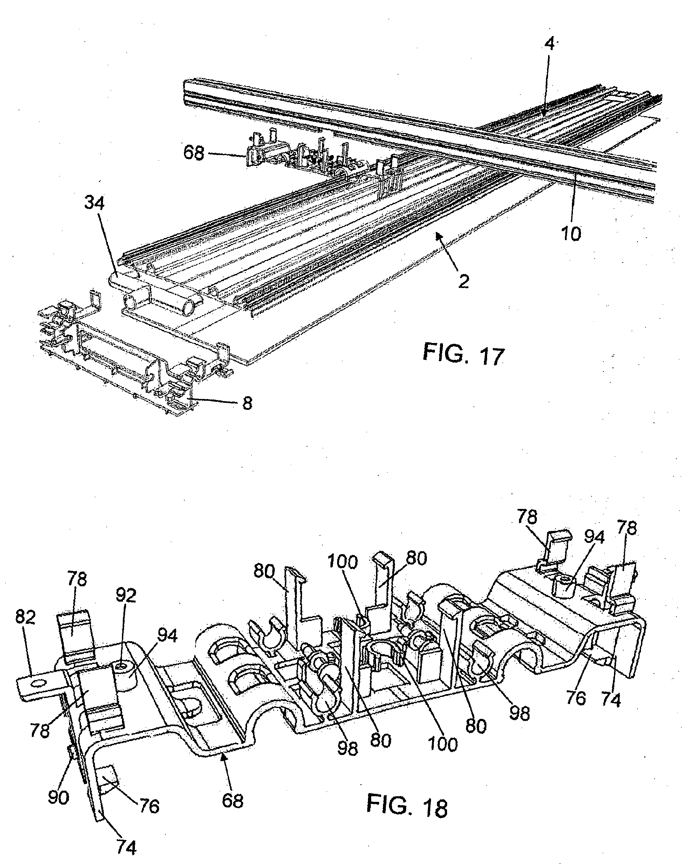

Cable lead-ins 98 (see Figure 18) can be provided on the lower face of the U-bracket 68 to the side of the hooks 80, for fixing the cables leaving the junction box 30, and in addition semi-cylindrical hooks 100 can be provided between the two pairs of hooks 80, to engage with pins 102 projecting from the upper surface of the fixing profile 10 (see Figure 25).

In the embodiment shown in Figure 26, the fixing profile 10 is formed such as to provide a tubular conduit 104, with connection tubes 106 applied to its lateral walls by welding or screwing. This embodiment is particularly advantageous in that it enables the intermediate profile 10 to be used both as a fixing support and as a hydraulic distribution manifold. Apart from this, independently of whether the hydraulic circuit consists of pipes which are external to the fixing profiles for the hybrid modules of the invention or are provided inside these, preferably flexible pipes are provided for connecting each hybrid module to said hydraulic circuit.

In the embodiment shown in Figures 27-31, the extruded profile 4 presents, in the zone between the two open longitudinal grooves 26, cylindrical seats 108 extending circumferentially through more than 180°, to insertingly house a flexible conduit 110 for thermovector fluid circulation. This conduit is preferably made of polyamide, a material of good mechanical strength and chemical resistance, plus high flexibility.

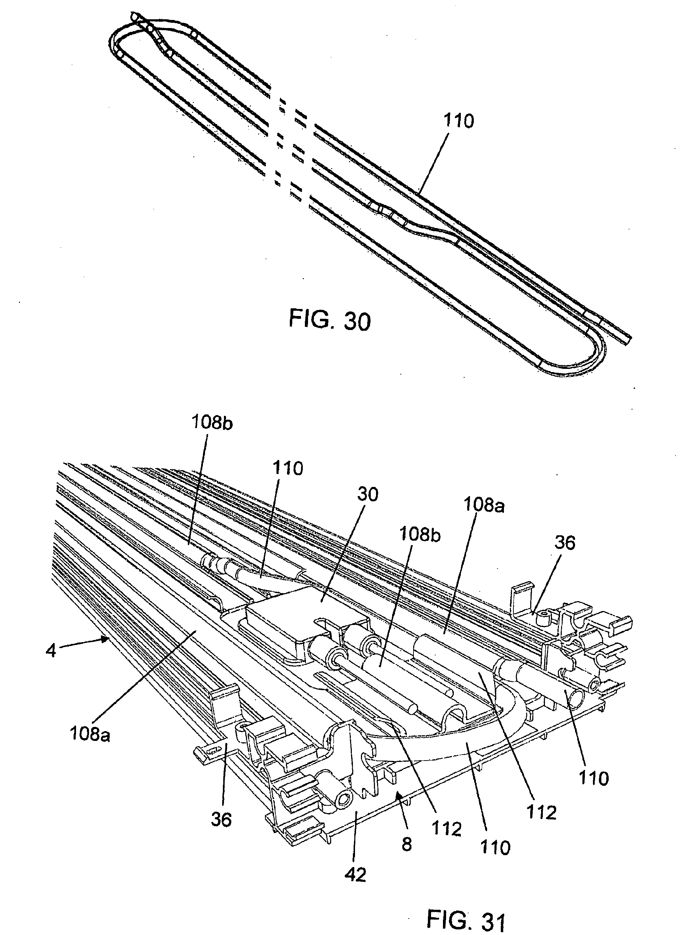

In greater detail, three longitudinal seats are provided housing a single spirally extending conduit 110 (see Figure 30), with one termination opening into a headpiece 8 of the hybrid module and the other termination opening into the other headpiece.

The two outer longitudinal seats 108a extend rectilinearly parallel to the adjacent edge of the profile 4, while for constructional reasons the central seat 108b extends rectilinearly but is interrupted in proximity to the junction box 30.

In the profile 4, ribs 112 are provided, arched towards the longitudinal seats 108a to guide those portions of the conduit 110 defining two loops at the two headpieces 8 of the hybrid module.

This particular shaping of the lower surface of the extruded profile 4 results at the same time in an increase in the heat exchange surface between the profile 4 and the conduit 110 and also enables the number of connections for one and the same hybrid module to be reduced. This is particularly advantageous for hybrid modules having a limited width of substantially between 18 and 20 cm, and a length equal to about 2 metres.

As shown in Figure 31, the tube 110 is firstly inserted, from one end of the extruded profile 4, into a lateral longitudinal seat 108a, to then extend to the opposite end, where the conduit is bent through 180° so that it can be inserted into the other longitudinal seat 108a, to then extend as far as the first end of the hybrid module. At this first end, the conduit 110 is again bent through 180° and made to extend parallel to the first portion until it passes beyond the junction box 30. From there onwards the conduit 110 is deviated centrally and is inserted into the central longitudinal seat 108b to then leave the module from the opposite end to the entering end. The conduit 110 could also be made to extend while adhering to the extruded profile 4 in accordance with a different path from the spiral path just described, for example along an S-shaped path.

In all cases, independently of the path taken by the conduit 110, flexible pipes are provided for connecting this conduit to the conduit 110 of other modules and/or to an external manifold circuit.

## Claims

1. A hybrid solar module for the simultaneous production of electric and thermic energy comprising a photovoltaic laminate (2) adhering to an extruded support profile (4), with which at least one conduit (7, 110) is associated for passage of a thermovector fluid for heat exchange with said photovoltaic laminate (2), **characterised by** comprising at the two ends of said extruded profile (4), two headpiece elements (8) acting in the sense of locking said photovoltaic laminate (2) to said extruded support profile (4) and of locking the combined said photovoltaic laminate (2) and said extruded support profile (4) to fixing profiles (10) foreseen on a fixed structure.

2. A module as claimed in claim 1, **characterised in that** said conduit (7) is formed in one piece with said extruded support profile (4).

3. A module as claimed in claim 1, **characterised in that** said conduit (110) consists of a flexible tubular element at least partially housed in grooved seats (108) provided in said extruded support profile (4).

4. A module as claimed in claim 1, **characterised in that** associated with said extruded support profile (4) there is a single conduit (110) bent several times on itself to adhere to said profile.

5. A module as claimed in one or more of the preceding claims, **characterised in that** each headpiece element (8) is provided with centring means (12) cooperating with complementary means (16) provided in said extruded support profile (4).

6. A module as claimed in one or more of the preceding claims, **characterised in that** each headpiece element (8) is provided with means for its stable fixing to said extruded support profile (4).

7. A module as claimed in one or more of the preceding claims, **characterised in that** each headpiece element (8) comprises means (36) for its snap-fixing to said fixing profiles (10).

8. A module as claimed in claim 7, **characterised in that** each headpiece element (8) comprises at least one fork element (36), the ends of each prong of which comprises at least one rib (38) cooperating with a groove (40) provided in said fixing profile (10).

9. A module as claimed in claim 8, **characterised in that** at least one fork element (36) of each headpiece element (8) is provided with at least one appendix (66) for its fixing to the fork element (36) of an adjacent module.

10. A module as claimed in one or more of the preceding claims, **characterised in that** the extruded support profile (4) presents a seat (28) for housing a junction box (30) for electric cables of the photovoltaic laminate (2), said seat (28) and said box being positioned in proximity to at least one tubular conduit (7, 110).

11. A module as claimed in one or more of the preceding claims, **characterised by** comprising fixing means (44, 68) applicable to the edges of said extruded support profile (4) and acting in the sense of fixing said photovoltaic laminate (2) thereto and of snap-fixing the combination formed by the pair to intermediate fixing profiles (10).

12. A module as claimed in claim 11, **characterised in that** said fixing means (44, 68) are provided with means for counteracting the transverse and longitudinal movements of said means with respect to said extruded support profile (4).

13. A module as claimed in one or more of the preceding claims, **characterised by** comprising hydraulic connections for connecting said conduit (7, 110) to an external manifold circuit.

14. A module as claimed in claim 13, **characterised in that** said intermediate fixing profile (10) comprises at least one tubular conduit (104) provided in its interior and forming said external manifold.

## Patentansprüche

1. Hybrid-Solarmodul zur gleichzeitigen Erzeugung von elektrischer und thermischer Energie, umfassend ein Photovoltaiklaminat (2), das an einem extrudierten Trägerprofil (4) haftet, an das mindestens eine Rohrlei-tung (7, 110) angegliedert ist, um ein Thermovektorfluid zum Wärme-tausch mit dem Photovoltaiklaminat (2) hindurchzuleiten, dadurch ge-kennzeichnet, dass es an den beiden Enden des extrudierten Profils (4) zwei Kopfstück¬elemente (8) umfasst, die zum Arretieren des Photovoltai-klaminats (2) an dem extrudierten Trägerprofil (4) und Arretieren des kom-binierten Photovoltaiklaminats (2) und extrudierten Trägerprofils (4) an Befestigungsprofilen (10) wirken, die an einer befestigten Struktur vorge-sehen sind.

2. Modul nach Anspruch 1, **dadurch gekennzeichnet, dass** die Rohrleitung (7) einteilig mit dem extrudierten Trägerprofil (4) gebildet ist.

3. Modul nach Anspruch 1, **dadurch gekennzeichnet, dass** die Rohrleitung (110) aus einem flexiblen röhrenförmigen Element besteht, das mindestens teilweise in mit Nuten versehenen Sitzen (108) aufge-nommen ist, mit denen das extrudierte Trägerprofil (4) ausgestattet ist.

4. Modul nach Anspruch 1, **dadurch gekennzeichnet, dass** an das extrudierte Trägerprofil (4) eine einzelne Rohrleitung (110) angegliedert ist, die mehrfach an sich selbst gebogen ist, um an dem Profil zu haften.

5. Modul nach einem oder mehreren der vorhergehenden Ansprü-che, **dadurch gekennzeichnet, dass** jedes Kopfstückelement (8) mit Zentriermitteln (12) ausgestattet ist, die mit Komplementärmitteln (16) zu-sammenwirken, mit denen das extrudierte Trägerprofil (4) ausgestattet ist.

6. Modul nach einem oder mehreren der vorhergehenden Ansprü-che, **dadurch gekennzeichnet, dass** jedes Kopfstückelement (8) mit Mitteln ausgestattet ist, um es stabil an dem extrudierten Trägerprofil (4) zu befestigen.

7. Modul nach einem oder mehreren der vorhergehenden Ansprü-che, **dadurch gekennzeichnet, dass** jedes Kopfstückelement (8) Mittel (36) zu seiner Schnappbefestigung an den Befestigungsprofilen (10) umfasst.

8. Modul nach Anspruch 7, **dadurch gekennzeichnet, dass** jedes Kopfstückelement (8) mindestens ein Gabelelement (36) umfasst, wobei die Enden jedes seiner Zinken mindestens eine Rippe (38) umfassen, die mit einer in dem Befestigungsprofil (10) bereitgestellten Nut (40) zusam-menwirkt.

9. Modul nach Anspruch 8, **dadurch gekennzeichnet, dass** mindes-tens ein Gabelelement (36) jedes Kopfstückelements (8) mit mindestens einem Anhang (66) ausgestattet ist, um es an dem Gabelelement (36) ei-nes benachbarten Moduls zu befestigen.

10. Modul nach einem oder mehreren der vorhergehenden Ansprü-che, **dadurch gekennzeichnet, dass** das extrudierte Trägerprofil (4) einen Sitz (28) zur Aufnahme einer Anschlussdose (30) für Elektrokabel des Photovoltaiklaminats (2) aufweist, wobei der Sitz (28) und die Dose in der Nähe von mindestens einer röhrenförmigen Rohrleitung (7, 110) positio-niert sind.

11. Modul nach einem oder mehreren der vorhergehenden Ansprü-che, **dadurch gekennzeichnet, dass** es Befestigungsmittel (44, 68) um-fasst, die an den Rändern des extrudierten Trägerprofils (4) anbringbar sind und zur Befestigung des Photovoltaiklaminats (2) daran und zur Schnappbefestigung der durch das Paar gebildeten Kombination an Zwi-schenbefestigungsprofilen (10) wirken.

12. Modul nach Anspruch 11, **dadurch gekennzeichnet, dass** die Befestigungsmittel (44, 68) mit Mittel ausgestattet sind, um den quer- und längsgerichteten Bewegungen der Mittel in Bezug auf das extrudierte Trägerprofil (4) entgegenzuwirken.

13. Modul nach einem oder mehreren der vorhergehenden Ansprü-che, **dadurch gekennzeichnet, dass** es hydraulische Anschlüsse umfasst, um die Rohrleitung (7, 110) an einem externen Verteilerkreislauf anzu-schließen.

14. Modul nach Anspruch 13, **dadurch gekennzeichnet, dass** das Zwischenbefestigungsprofil (10) mindestens eine röhrenförmige Rohrlei-tung (104) umfasst, die in seinem Inneren bereitgestellt wird und den ex-ternen Verteiler bildet.

## Revendications

1. Module solaire hybride pour la production simultanée d'énergie électrique et thermique, comprenant un stratifié photovoltaïque (2) qui adhère à un profilé de support extrudé (4) auquel au moins un conduit (7, 110) est associé pour le passage d'un fluide thermovecteur en vue de réaliser un échange de chaleur avec ledit stratifié photovoltaïque (2), **caractérisé en ce qu'**il comprend aux deux extrémités dudit profilé extrudé (4), deux éléments de coiffe (8) qui agissent dans le sens d'un verrouillage dudit stratifié photovoltaïque (2) audit profilé de support extrudé (4) et d'un verrouillage dudit stratifié photovoltaïque (2) et dudit profilé de support extrudé (4) combinés à des profilés de fixation (10) prévus sur une structure fixe.

2. Module selon la revendication 1, **caractérisé en ce que** ledit conduit (7) est formé d'une seule pièce avec ledit profilé de support extrudé (4).

3. Module selon la revendication 1, **caractérisé en ce que** ledit conduit (110) consiste en un élément tubulaire flexible qui est au moins partiellement logé dans des sièges rainurés (108) prévus dans ledit profilé de support extrudé (4).

4. Module selon la revendication 1, **caractérisé en ce qu'**un seul conduit (110) plié plusieurs fois sur lui-même afin d'adhérer audit profilé est associé audit profilé de support extrudé (4).

5. Module selon une ou plusieurs des revendications précédentes, **caractérisé en ce que** chaque élément de coiffe (8) est pourvu de moyens de centrage (12) qui coopèrent avec des moyens complémentaires (16) prévus dans ledit ledit profilé de support extrudé (4).

6. Module selon une ou plusieurs des revendications précédentes, **caractérisé en ce que** chaque élément de coiffe (8) est pourvu de moyens permettant sa fixation stable audit profilé de support extrudé (4).

7. Module selon une ou plusieurs des revendications précédentes, **caractérisé en ce que** chaque élément de coiffe (8) comprend des moyens (36) pour sa fixation par emboîtement auxdits profilés de fixation (10).

8. Module selon la revendication 7, **caractérisé en ce que** chaque élément de coiffe (8) comprend au moins un élément de fourche (36), dont les extrémités de chaque griffe comportent au moins une nervure (38) qui coopère avec une rainure (40) prévue dans ledit profilé de fixation (10).

9. Module selon la revendication 8, **caractérisé en ce qu'**au moins un élément de fourche (36) de chaque élément de coiffe (8) est pourvu d'au moins une languette (66) pour sa fixation à l'élément de fourche (36) d'un module adjacent.

10. Module selon une ou plusieurs des revendications précédentes, **caractérisé en ce que** le profilé de support extrudé (4) présente un siège (28) pour loger une boîte de raccordement (30) pour des câbles électriques du stratifié photovoltaïque (2), ledit siège (28) et ladite boîte étant positionnés à proximité d'au moins un conduit tubulaire (7, 110).

11. Module selon une ou plusieurs des revendications précédentes, **caractérisé en ce qu'**il comprend des moyens de fixation (44, 68) applicables aux bords dudit profilé de support extrudé (4) et qui agissent dans le sens de la fixation dudit stratifié photovoltaïque (2) à celui-ci et de la fixation par emboîtement de la combinaison formée par la paire à des profilés de fixation intermédiaires (10).

12. Module selon la revendication 11, **caractérisé en ce que** lesdits moyens de fixation (44, 68) sont pourvus de moyens pour contrecarrer les déplacements transversaux et longitudinaux desdits moyens par rapport audit profilé de support extrudé (4).

13. Module selon une ou plusieurs des revendications précédentes, **caractérisé en ce qu'**il comprend des connexions hydrauliques pour connecter ledit conduit (7, 110) à un circuit de collecteur externe.

14. Module selon la revendication 13, **caractérisé en ce que** ledit profilé de fixation intermédiaire (10) comprend au moins un conduit tubulaire (104) prévu à l'intérieur de celui-ci et qui forme ledit collecteur externe.
